# FASCICULE DE BREVET EUROPEEN

(11) **EP 4 145 160 B1**
(45) Date de publication et mention de la délivrance du brevet: **03.01.2024**
(21) Numéro de dépôt: 22194195.8
(22) Date de dépôt: 06.09.2022
(51) Int. Cl.: G01R 31/40

(54) **DISPOSITIF DE VÉRIFICATION DU FONCTIONNEMENT D'UN MODULE DE PUISSANCE**
VORRICHTUNG ZUR ÜBERPRÜFUNG DES ORDNUNGSGEMÄSSEN FUNKTIONIERENS EINES LEISTUNGSMODULS
DEVICE FOR CHECKING THE OPERATION OF A POWER MODULE

(30) Priorité: 06.09.2021 FR 2109305
(43) Date de publication de la demande: 08.03.2023
(73) Titulaire: ALSTOM Holdings, 93400 Saint-Ouen-sur-Seine (FR)
(72) Inventeur: MAURY, Cyril Sébastien, 65380 OSSUN (FR); LEPAGE, Jean-Pierre, 65800 AUREILHAN (FR); LAURENT, Sylvain, 37270 SAINT MARTIN LE BEAU (FR); BRETEAU, Marc, 37800 NOYANT DE TOURAINE (FR)
(74) Mandataire: Lavoix

(56) Documents cités:
- CN-U- 202 393 844
- CN-U- 207 408 507
- KR-A- 20210 028 312
- ZHARKIN ANDRII ET AL: "Development of Powerful Unified Inverter Modules for Energy Storage Systems", 2019 IEEE 6TH INTERNATIONAL CONFERENCE ON ENERGY SMART SYSTEMS (ESS), IEEE, 17 avril 2019 (2019-04-17), pages 144-149, XP033577051, DOI: 10.1109/ESS.2019.8764177

## Description

La présente invention concerne un dispositif de vérification du fonctionnement d'un module de puissance. La présente invention concerne aussi un ensemble électronique associé.

La chaîne de traction d'un véhicule ferroviaire comprend de nombreux composants capables de supporter des puissances élevées. L'un de ces composants est l'onduleur de traction dont la fonction est de générer un signal ayant une tension alternative et un courant alternatif à partir d'un signal ayant une tension continue et un courant continu.

Un onduleur comprend typiquement une entrée pour une tension d'entrée et un circuit de conversion d'énergie pour trois phases. Le circuit de conversion comprend trois branches de conversion connectées en parallèle aux bornes de l'entrée. Chaque branche de conversion comprend deux ensembles de composants connectés en série l'un à l'autre. Chaque ensemble de composants comprend au moins un interrupteur, par exemple, sous la forme d'un dispositif semi-conducteur, tel qu'un transistor IGBT, avec une diode connectée en antiparallèle.

Avant la mise en service ou lors de sessions de maintenance ou de réparation de l'onduleur de traction, il est courant d'effectuer des tests pour vérifier son bon fonctionnement.

Le document CN 207 408 507 U divulgue un système de test d'un module de puissance IGBT. Le module de puissance IGBT comprend une carte de pilotage IGBT, un module IGBT et un premier capteur de courant. Le système de test comprend un module d'alimentation en courant continu et un module de contrôle.

Pour réaliser de tels tests, il est notamment connu d'alimenter l'onduleur de traction avec une source d'alimentation alternative de grande puissance connectée à un redresseur. La source d'alimentation a typiquement une tension supérieure à 500 Volts et un courant supérieur à 100 Ampères. Une telle source d'alimentation permet de simuler la caténaire ou l'alimentation par le sol de véhicules ferroviaires. Le redresseur permet de disposer d'une tension continue en entrée de l'onduleur de traction. Les branches de conversion de l'onduleur sont quant à elles chacune connectées à des charges inductives, ce qui permet de simuler un moteur de traction.

Lors du test, les transistors de chacune des branches de conversion de l'onduleur sont pilotés selon la technique de la modulation par largeur d'impulsions (MLI). Le courant est mesuré dans chaque branche et les formes d'onde obtenues pour le courant pour chaque branche sont ensuite comparées à des formes d'onde de référence. Le fonctionnement de l'onduleur de traction est considéré valide lorsque les formes d'onde obtenues sont conformes aux formes d'ondes de référence.

Néanmoins, un tel test suppose de disposer d'une source de puissance conséquente en entrée, ainsi que d'un redresseur et de charges inductives permettant de supporter la puissance qui transite. Or, de tels composants sont volumineux et coûteux. En outre, étant donné les quantités d'énergie qui transitent dans ces composants, un système de refroidissement, lui aussi volumineux et coûteux est à mettre en place.

Il existe donc un besoin pour un dispositif de vérification du fonctionnement d'un module de puissance qui soit moins volumineux et moins consommateur d'énergie.

A cet effet, la présente description porte sur un dispositif de vérification du fonctionnement d'un module de puissance, le module de puissance comprenant une entrée pour une tension continue d'entrée et un circuit de conversion d'énergie pour trois phases, le circuit de conversion comprenant trois branches de conversion connectées en parallèle aux bornes de l'entrée, chaque branche de conversion comprenant deux ensembles de composants connectés en série l'un à l'autre, chaque ensemble comprenant au moins un interrupteur avec une diode connectée en antiparallèle, le dispositif de vérification comprenant :
a. un module amont destiné à être connecté aux bornes de l'entrée du module de puissance, le module amont comprenant une première source d'alimentation ayant une tension supérieure ou égale à une première borne de tension et un courant inférieur ou égal à une première borne de courant,
b. une branche outil comprenant deux ensembles de composants connectés en série l'un à l'autre, chaque ensemble comprenant au moins un interrupteur avec une diode connectée en antiparallèle, la branche outil étant destinée à être connectée en parallèle aux bornes de l'entrée du module de puissance,
c. un module aval connecté, d'une part, au point milieu entre les deux ensembles de composants de la branche outil et destiné à être connecté, d'autre part, au point milieu entre les deux ensembles de composants de l'une des branches de conversion, dite branche en test, de sorte à former une boucle de courant, le module aval comprenant une deuxième source d'alimentation ayant une tension strictement inférieure à une deuxième borne de tension et un courant strictement supérieur à une deuxième borne de courant,
d. un module de commande configuré pour commander les interrupteurs de la branche outil et de la branche en test selon une série de configurations prédéterminées,
e. un module de mesure configuré pour mesurer au cours du temps le courant dans la boucle de courant, et
f. un module de vérification configuré pour vérifier le fonctionnement de la branche en test en fonction du courant mesuré au cours du temps par le module de mesure.

Suivant des modes de réalisations particuliers, le dispositif comprend une ou plusieurs des caractéristiques suivantes, prises isolément ou suivant toutes les combinaisons techniquement possibles :
a. la première borne de tension est supérieure ou égale à 500 Volts, de préférence supérieure ou égale à 700 Volts, avantageusement supérieure ou égale à 1000 Volts,
b. la deuxième borne de tension est inférieure ou égale à 500 Volts, de préférence inférieure ou égale à 300 Volts, avantageusement inférieure ou égale à 200 Volts,
c. la première borne de courant est inférieure ou égale à 10 Ampères, de préférence inférieure ou égale à 5 Ampères, avantageusement inférieure ou égale à 1 Ampère, et
d. la deuxième borne de courant est supérieure ou égale à 10 Ampères, de préférence supérieure ou égale à 30 Ampères, avantageusement supérieure ou égale à 50 Ampères.
   - le module aval comprend un transformateur ayant un primaire et un secondaire, le primaire du transformateur étant connecté en parallèle de la deuxième source d'alimentation, le secondaire du transformateur étant connecté, d'une part, au point milieu entre les deux ensembles de composants de la branche outil et étant, d'autre part, destiné à être connecté au point milieu entre les deux ensembles de composants de la branche en test ;
   - le module aval comprend un circuit RL connecté en série du secondaire du transformateur ;
   - le module aval comprend un circuit inverseur, tel qu'un pont en H, le circuit inverseur étant connecté en parallèle de la deuxième source d'alimentation et étant commandé par le module de commande ;
   - la série de configurations prédéterminées du module de vérification comprend au moins les configurations suivantes : une première configuration dans laquelle le ou les interrupteurs de chaque ensemble sont ouverts, une deuxième configuration dans laquelle seuls le ou les interrupteurs de l'un des ensembles de la branche en test est fermé, une troisième configuration dans laquelle seul(s) le ou les interrupteurs de l'un des ensembles de la branche outil est fermé, une quatrième configuration dans laquelle seul(s) le ou les interrupteurs de l'autre des ensembles de la branche en test est fermé et une cinquième configuration dans laquelle seul(s) le ou les interrupteurs de l'autre des ensembles de la branche outil est fermé ;
   - le module de vérification est configuré pour comparer la forme du signal représentatif du courant mesuré au cours du temps par le module de mesure, à une forme d'un signal de référence.

La présente description porte également sur une installation électrique comprenant :
a. un module de puissance comprenant une entrée pour une tension continue d'entrée et un circuit de conversion d'énergie pour trois phases, le circuit de conversion comprenant trois branches de conversion connectées en parallèle aux bornes de l'entrée, chaque branche de conversion comprenant deux ensembles de composants connectés en série l'un à l'autre, chaque ensemble comprenant au moins un interrupteur avec une diode connectée en antiparallèle,
b. un dispositif de vérification du fonctionnement du module de puissance, le dispositif de vérification tel que décrit précédemment

Suivant des modes de réalisations particuliers, l'installation comprend une ou plusieurs des caractéristiques suivantes, prises isolément ou suivant toutes les combinaisons techniquement possibles :
- la branche outil du dispositif de vérification est une branche de conversion du module de puissance, différente de la branche en test ;
- le module de puissance est configuré pour fonctionner sous une puissance supérieure ou égale à 500 Kilowatt, de préférence supérieure ou égale à 1 Mégawatt.

D'autres caractéristiques et avantages de l'invention apparaîtront à la lecture de la description qui suit de modes de réalisation de l'invention, donnée à titre d'exemple uniquement, et en référence aux figures suivantes :
- [Fig 1], la figure 1 est une représentation schématique d'un exemple d'un ensemble électronique comprenant un dispositif de vérification et un module de puissance à tester, les interrupteurs d'une branche en test et d'une branche outil étant commandés selon une première configuration (à l'arrêt),
- [Fig 2], la figure 2 est une représentation schématique de l'ensemble de la figure 1, les interrupteurs de la branche en test et de la branche outil étant commandés selon une deuxième configuration,
- [Fig 3], la figure 3 est une représentation schématique de l'ensemble de la figure 1, les interrupteurs de la branche en test et de la branche outil étant commandés selon une troisième configuration,
- [Fig 4], la figure 4 est une représentation schématique de l'ensemble de la figure 1, les interrupteurs de la branche en test et de la branche outil étant commandés selon une quatrième configuration,
- [Fig 5], la figure 5 est une représentation schématique de l'ensemble de la figure 1, les interrupteurs de la branche en test et de la branche outil étant commandés selon une cinquième configuration, et
- [Fig 6], la figure 6 est un chronogramme représentatif respectivement des commandes des interrupteurs des branches en test et outil, de l'intensité du courant dans la boucle de courant, et de la tension aux bornes de chacun des interrupteurs des branches en test et outil.

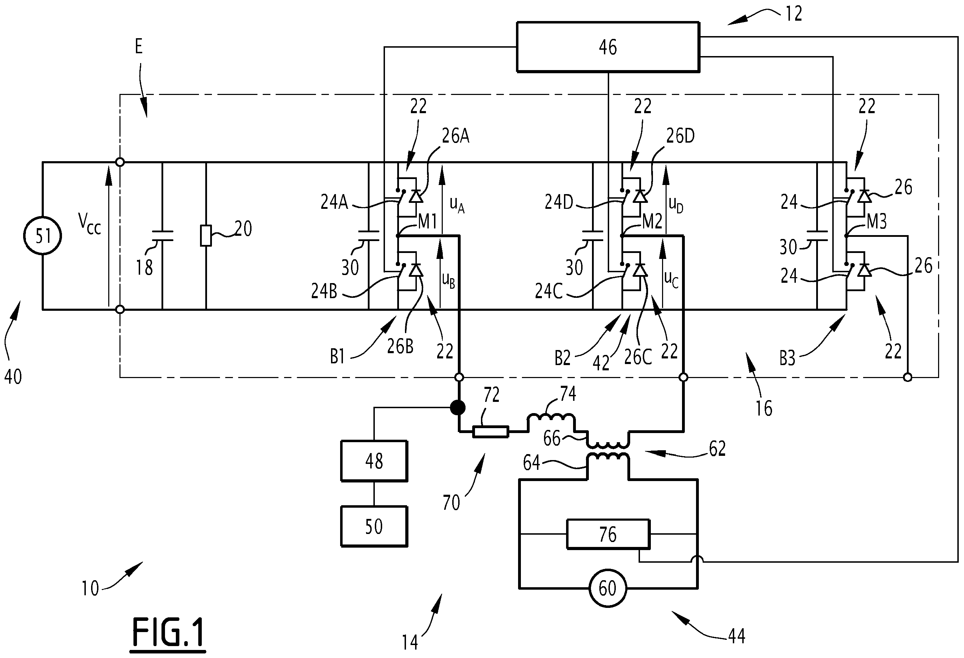

Un exemple d'une installation électrique 10 comprenant un module de puissance 12 et un dispositif 14 de vérification du fonctionnement du module de puissance 12 est illustré par les figures 1 à 5.

Avantageusement, le module de puissance 12 est configuré pour fonctionner sous une puissance supérieure ou égale à 500 Kilowatt (kW), de préférence supérieure ou égale à 1 Mégawatt (MW). Le module de puissance 12 est, par exemple, un onduleur de traction.

Le module de puissance 12 comprend une entrée E et un circuit 16 de conversion d'énergie pour trois phases.

L'entrée E est propre à recevoir une tension continue d'entrée Vcc sous un courant continu d'entrée.

Optionnellement, comme illustré par les figures 1 à 5, au moins un condensateur 18 et au moins une résistance 20 sont chacun connectés en parallèle aux bornes de l'entrée E. Le condensateur 18 permet de stabiliser la tension arrivant dans le circuit 16 de conversion d'énergie. La résistance 20 est une résistance de décharge dont le rôle est de décharger l'énergie stockée dans le condensateur 18 lorsque le dispositif de vérification 14 est arrêté.

Le circuit 16 de conversion d'énergie comprend au moins trois branches B1, B2, B3 de conversion d'énergie. Chaque branche de conversion B1, B2, B3 est connectée en parallèle aux bornes de l'entrée E. Chaque branche de conversion B1, B2, B3 comprend deux ensembles 22 de composants. Les deux ensembles 22 de composants sont connectés en série l'un à l'autre en un point milieu M1, M2, M3.

Chaque branche de conversion B1, B2, B3 est destinée à être connectée à une phase d'un réseau triphasé, tel qu'un moteur triphasé. La connexion est dans ce cas réalisée au point milieu M1, M2, M3 entre les deux ensembles 22 de composants de la branche de conversion B1, B2, B3 correspondante.

Chaque ensemble 22 comprend au moins un interrupteur 24, chaque interrupteur 24 étant associé à une diode 26 connectée en antiparallèle (tête-bêche) de l'interrupteur 24. Lorsqu'un ensemble 22 comprend plusieurs interrupteurs 24, lesdits interrupteurs 24 sont connectés en parallèle et forment, ainsi, des packs d'interrupteurs 24.

De préférence, le ou les interrupteurs 24 de chaque ensemble 22 sont des éléments semi-conducteurs, tels que des transistors bipolaires à grille isolée (IGBT).

Avantageusement, les composants de chaque ensemble 22 sont identiques les uns aux autres de sorte que les branches de conversion B1, B2, B3 ont les mêmes composants et sont identiques.

Optionnellement, comme illustré par les figures 1 à 5, le circuit de conversion 16 comprend, pour chaque branche de conversion B1, B2, B3, au moins un condensateur 30 connecté en parallèle de ladite branche de conversion B1, B2, B3 (et donc en parallèle aux bornes de l'entrée E). De tels condensateurs 30 permettent de stabiliser la tension aux bornes de chaque branche de conversion B1, B2, B3.

Le dispositif de vérification 14 est configuré pour vérifier le bon fonctionnement du module de puissance 12. En particulier, le dispositif de vérification 14 est configuré pour tester le bon fonctionnement de chacune des branches de conversion B1, B2, B3 du module de puissance 12.

Le dispositif de vérification 14 comprend un module amont 40, une branche outil 42, un module aval 44, un module de commande 46, un module de mesure 48 et un module de vérification 50.

Le module amont 40 est destiné à être connecté aux bornes de l'entrée E du module de puissance 12, comme cela est le cas sur les figures 1 à 5. Le module amont 40 fournit, ainsi, la tension d'entrée Vcc continue au module de puissance 12.

Le module amont 40 comprend une première source d'alimentation 51 ayant une tension supérieure ou égale à une première borne de tension et un courant inférieur ou égal à une première borne de courant.

Dans un mode de réalisation, la première source d'alimentation 51 est propre à délivrer une tension continue (sous un courant continu). En variante, la première source d'alimentation 51 est propre à délivrer une tension alternative (sous un courant alternatif) qui est ensuite convertie en tension continue par un redresseur intégré dans le module amont 40.

Avantageusement, la première borne de tension est supérieure ou égale à 500 Volts, de préférence supérieure ou égale à 700 Volts, encore plus avantageusement supérieure ou égale à 1000 Volts. Avantageusement, la première borne de courant est inférieure ou égale à 10 Ampères, de préférence inférieure ou égale à 5 Ampères, encore plus avantageusement inférieure ou égale à 1 Ampère.

Par exemple, la tension de la première source d'alimentation 51 est égale à 1000 Volts (V) et le courant de la première source d'alimentation 51 est égal à 1 Ampères (A).

La branche outil 42 comprend deux ensembles 22 de composants connectés en série l'un à l'autre. Chaque ensemble 22 comprend au moins un interrupteur 24, chaque interrupteur 24 étant associé à une diode 26 connectée en antiparallèle de l'interrupteur 24. Lorsqu'un ensemble 22 comprend plusieurs interrupteurs 24, lesdits interrupteurs 24 sont connectés en parallèle et forment, ainsi, des packs d'interrupteurs 24. De préférence, le ou les interrupteurs 24 de chaque ensemble 22 sont des éléments semi-conducteurs, tels que des IGBT.

Avantageusement, la branche outil 42 comprend les mêmes composants que l'une des branches de conversion B1, B2, B3.

La branche outil 42 est destinée à être connectée en parallèle aux bornes de l'entrée E du circuit de conversion d'énergie 16.

Dans l'exemple illustré sur les figures 1 à 5, la branche outil 42 est l'une des trois branches de conversion B1, B2, B3 du circuit de conversion d'énergie 16, différente de la branche en test (en l'occurrence la branche B2 est la branche outil 42 et la branche B1 est la branche en test). Cela permet de simplifier la conception du dispositif de vérification 14 et de faciliter la mise en oeuvre de la vérification effectuée.

Dans l'exemple illustré sur les figures 1 à 5, pour la branche en test, l'interrupteur du « haut » est appelé 24A et la diode associée 26A, et l'interrupteur du « bas » est appelé 24B et la diode associée 26B. Pour la branche outil, l'interrupteur du « haut » est appelé 24D et la diode associée 26D, et l'interrupteur du « bas » est appelé 24C et la diode associée 26C.

En variante, la branche outil 42 est distincte des branches de conversion B1, B2, B3 du circuit de conversion d'énergie 16. Dans ce cas, il convient de connecter la branche outil 42 au circuit de conversion d'énergie 16.

Le module aval 44 est connecté, d'une part, au point milieu entre les deux ensembles 22 de composants de la branche outil 42. D'autre part, le module aval 44 est destiné à être connecté au point milieu M1, M2, M3 entre les deux ensembles 22 de composants de l'une des branches de conversion B1, B2, B3, dite branche en test, de sorte à former une boucle de courant. Le courant circule alors dans cette boucle de courant. Une telle connexion est illustrée sur les figures 1 à 5, la branche de conversion B1 étant alors la branche en test.

Le module aval 44 comprend une deuxième source d'alimentation 60 ayant une tension strictement inférieure à une deuxième borne de tension et un courant strictement supérieur à une deuxième borne de courant.

Avantageusement, la deuxième borne de tension est inférieure ou égale à 500 Volts, de préférence inférieure ou égale à 300 Volts, encore plus avantageusement inférieure ou égale à 200 Volts. Avantageusement, la deuxième borne de courant est supérieure ou égale à 10 Ampères, de préférence supérieure ou égale à 30 Ampères, encore plus avantageusement supérieure ou égale à 50 Ampères.

Par exemple, la tension de la deuxième source d'alimentation 60 est égale à 200 V et le courant de la deuxième source d'alimentation 60 est égal à 50 A.

Dans le mode de réalisation illustré par les figures 1 à 5, le module aval 44 comprend un transformateur 62 ayant un primaire 64 et un secondaire 66. Le primaire 64 du transformateur 62 est connecté en parallèle de la deuxième source d'alimentation 60. Le secondaire 66 du transformateur 62 est connecté, d'une part, au point milieu entre les deux ensembles 22 de composants de la branche outil 42 et est, d'autre part, destiné à être connecté au point milieu M1, M2, M3 entre les deux ensembles 22 de composants de la branche en test.

Avantageusement, le rapport de transformation du transformateur 62 est compris entre 15 et 25, de préférence est égal à 20.

Dans le mode de réalisation illustré par les figures 1 à 5, le module aval 44 comprend un circuit RL 70 connecté en série au secondaire 66 du transformateur 62. Le secondaire 66 du transformateur 62 est destiné à être connecté au point milieu M1, M2, M3 entre les interrupteurs 24 de la branche en test par l'intermédiaire du circuit RL 70. Le circuit RL 70 comprend une résistance 72 et une bobine 74. Un tel circuit RL 70 permet de limiter la vitesse de montée du courant dans la boucle.

Dans le mode de réalisation illustré par les figures 1 à 5, le module aval 44 comprend un circuit inverseur 76 connecté en parallèle de la deuxième source d'alimentation 60. Le circuit inverseur 76 permet d'inverser le sens du courant dans le secondaire 66 du transformateur 62.

Le circuit inverseur 76 est, par exemple, un pont en H. Un pont en H comprend quatre éléments de commutation généralement disposés schématiquement en une forme de H d'où le nom. Les commutateurs sont des relais, des transistors, ou tout autres éléments de commutation.

Le module de commande 46 est configuré pour commander les interrupteurs 24 de la branche outil 42 et de la branche en test selon une série de configurations prédéterminées. Cela permet d'imposer différentes phases temporelles pour le courant dans la boucle de courant. Le cas échéant, le module de commande 46 est également configuré pour commander le circuit inverseur 76.

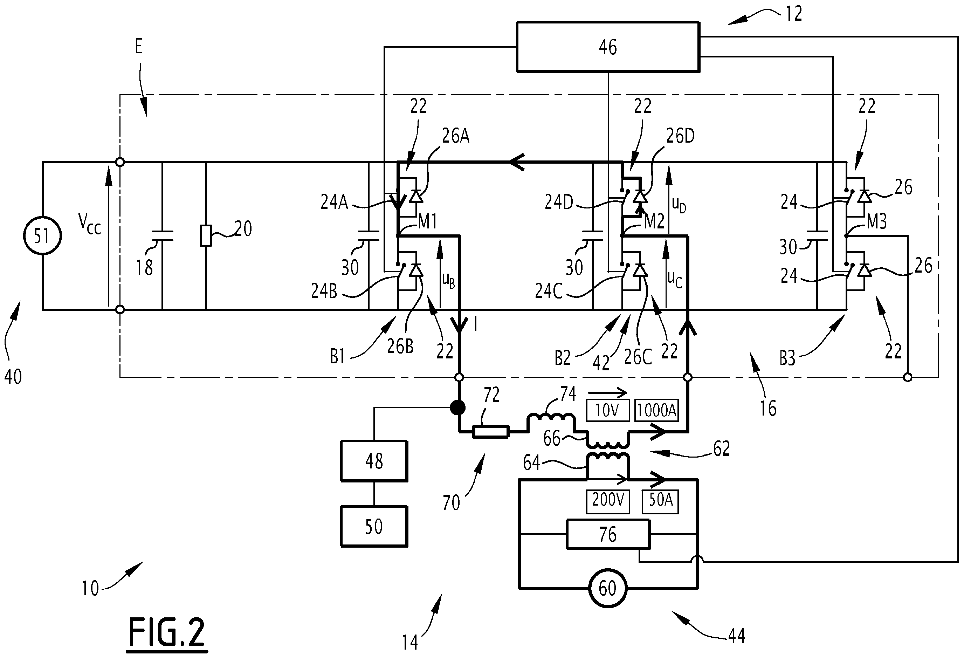

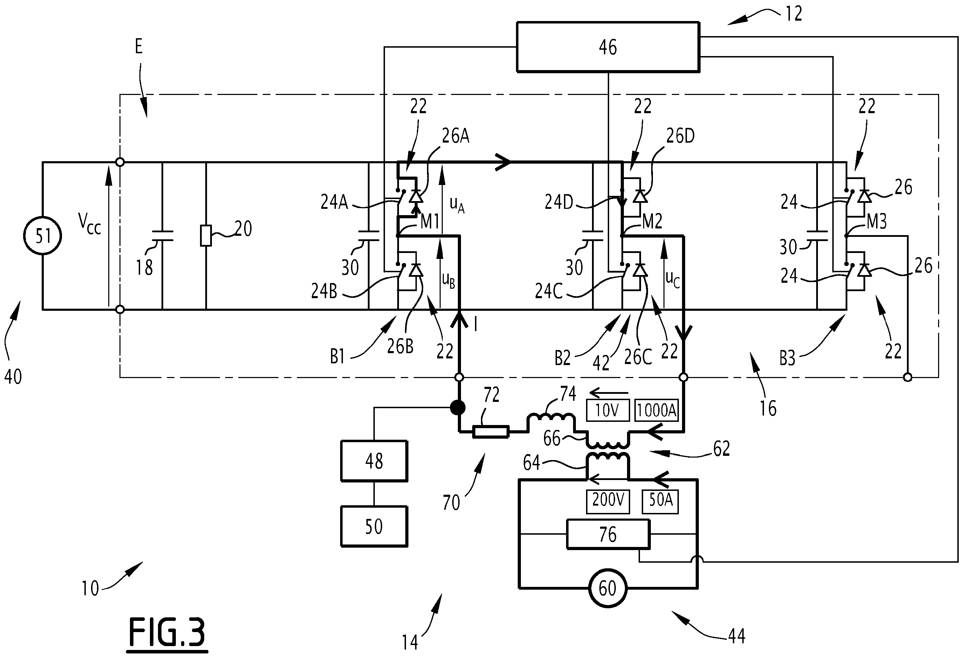

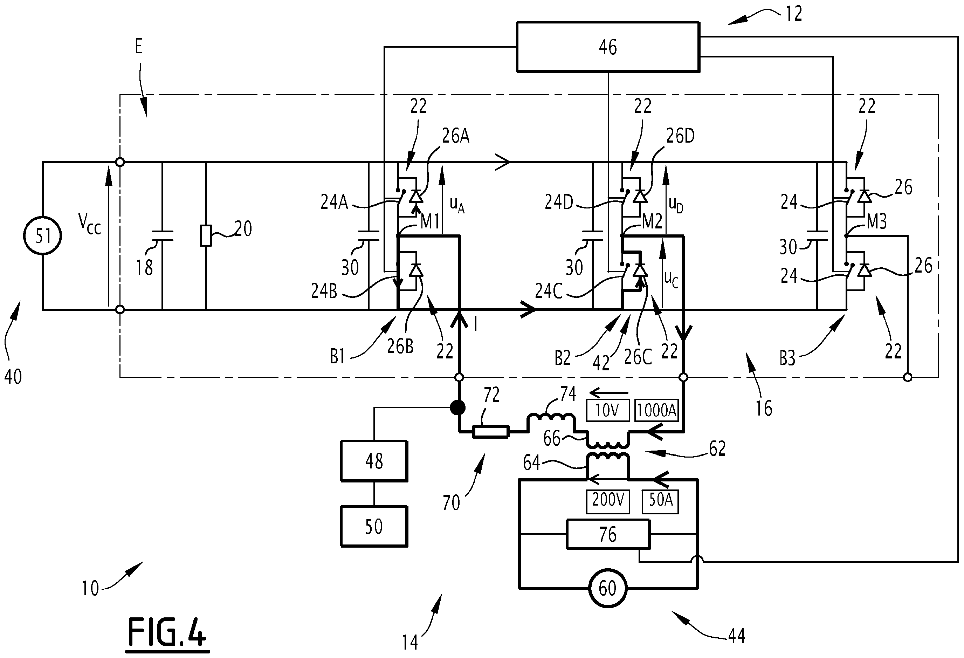

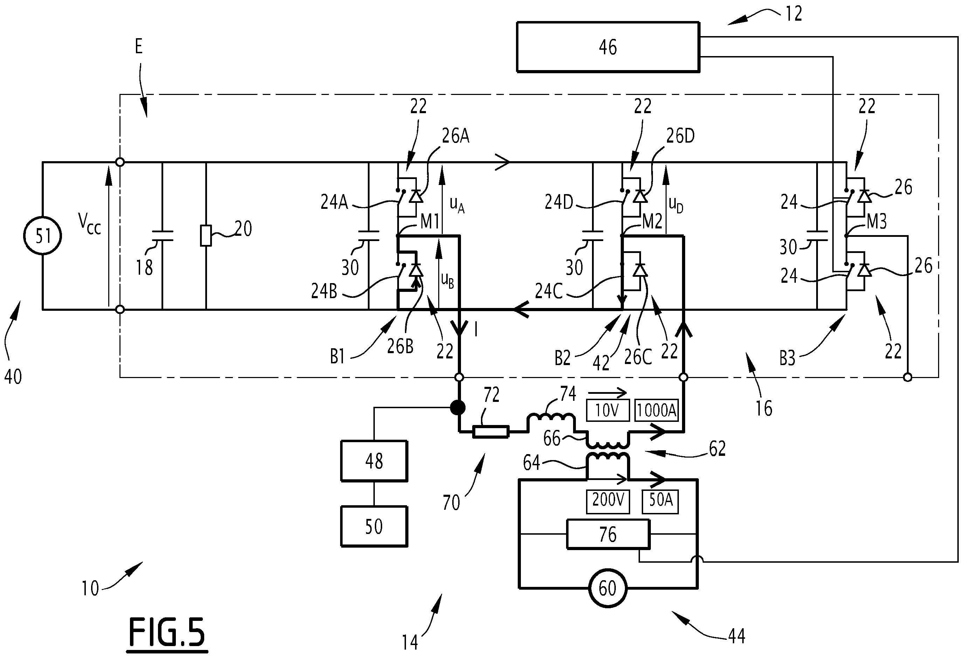

Avantageusement, la série de configurations prédéterminées comprend au moins les configurations suivantes :
- une première configuration, illustrée par la figure 1, dans laquelle le ou les interrupteurs 24 de chaque ensemble 22 sont ouverts. Dans une telle configuration, le dispositif de vérification 14 est à l'arrêt.
- une deuxième configuration, illustrée par la figure 2, dans laquelle seuls le ou les interrupteurs 24 de l'un des ensembles 22 de la branche en test est fermé.
- une troisième configuration, illustrée par la figure 3, dans laquelle seul(s) le ou les interrupteurs 24 l'un des ensembles 22 de la branche outil 42 est fermé.
- une quatrième configuration, illustrée par la figure 4, dans laquelle seul(s) le ou les interrupteurs 24 de l'autre des ensembles 22 de la branche en test est fermé.
- une cinquième configuration, illustrée par la figure 5, dans laquelle seul(s) le ou les interrupteurs 24 de l'autre des ensembles 22 de la branche outil est fermé.

Par le terme « ouvert » pour un interrupteur, il est entendu que l'interrupteur est non-passant. Par le terme « fermé » pour un interrupteur, il est entendu que l'interrupteur est passant, c'est-à-dire qu'il permet le passage du courant.

Le module de commande 46 fonctionne avantageusement de manière synchrone avec le module de sortie 44.

Le module de mesure 48 est configuré pour mesurer au cours du temps le courant dans la boucle de courant. Le courant mesuré est donc le courant circulant dans la branche en test et dans la branche outil 42.

Le module de mesure 48 est, par exemple, un ampèremètre.

Le module de vérification 50 est configuré pour vérifier le fonctionnement de la branche en test en fonction du courant mesuré au cours du temps par le module de commande 46.

En particulier, dans un exemple, le module de vérification 50 est configuré pour comparer la forme du signal représentatif du courant mesuré au cours du temps par le module de mesure 48 à une forme d'un signal de référence et à déterminer si le fonctionnement de la branche en test est valide ou non en fonction du résultat de la comparaison.

Un exemple de fonctionnement de l'installation électrique 10 va maintenant être décrit.

Initialement, le dispositif de vérification 14 est connecté au module de puissance 12 de la manière suivante :
- le module amont 40 est connecté en parallèle aux bornes de l'entrée E du module de puissance 12,
- le cas échéant (lorsque la branche outil 42 est différente d'une branche de conversion B1, B2, B3), la branche outil 42 est connectée en parallèle aux bornes de l'entrée E du module de puissance 12, et
- le module aval 44 est connecté, d'une part, au point milieu entre les deux ensembles 22 de composants de la branche outil 42, et d'autre part, au point milieu M1, M2, M3 entre les deux ensembles 22 de composants de la branche en test.

Initialement, le dispositif de vérification 14 est à l'arrêt, c'est-à-dire que le module de commande 46 commande les interrupteurs 24 de la branche en test et de la branche outil 42 selon la première configuration.

En fonctionnement, le module de commande 46 commande au cours du temps les interrupteurs 24 selon la deuxième, puis la troisième, puis la quatrième et enfin la cinquième configuration, et ainsi de suite jusqu'à l'arrêt du dispositif de vérification 14. Le module de commande 46 commande également le circuit inverseur 76.

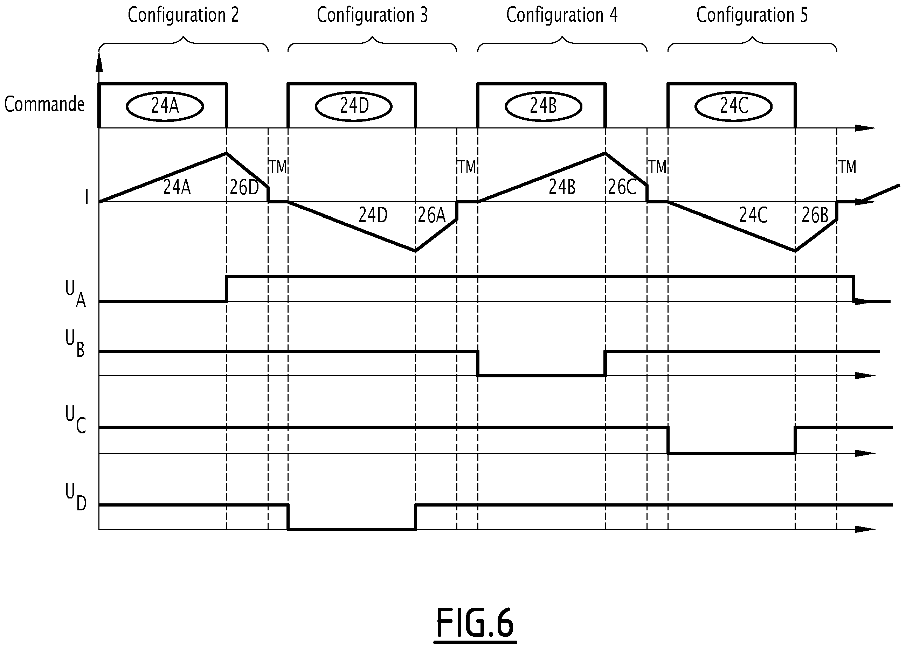

Le passage d'une configuration à une autre s'effectue avec un temps mort TM (illustré en figure 6), c'est-à-dire que tous les interrupteurs 24 sont ouverts pendant ce temps mort (configuration 1). La durée du temps mort est typiquement 10µs, c'est une valeur en rapport avec le type d'IGBT utilisé.

Dans la deuxième configuration illustrée en figure 2, seule la tension aux bornes de l'ensemble 22 « du haut » de la branche en test est nulle. Le courant circule dans l'interrupteur 24A de l'ensemble 22 « du haut » de la branche en test et dans la diode 26D en antiparallèle de l'interrupteur 24D de l'ensemble 22 « du haut » de la branche outil 42. En outre, dans le primaire 64 du transformateur 62, le courant circule dans un premier sens fixé par le circuit inverseur 76 commandé par le module de commande 46.

Ainsi, dans la deuxième configuration, comme illustré par la figure 6, le courant passe dans l'interrupteur 24A et augmente en continu en partant de zéro tant que l'interrupteur 24A est fermé. Tant que l'interrupteur 24A est fermé, la tension U_{A} aux bornes de l'interrupteur 24A est nulle. Puis, une fois l'interrupteur 24A rouvert, le courant passe dans la diode 26D en antiparallèle de l'interrupteur 24D et diminue jusqu'à atteindre à nouveau la valeur nulle. Le passage dans la troisième configuration se fait alors avec un temps mort TM.

Dans la troisième configuration illustrée en figure 3, seule la tension aux bornes de l'ensemble 22 « du haut » de la branche outil 42 est nulle. Le courant circule dans l'interrupteur 24D de l'ensemble 22 « du haut » de la branche outil 42 et dans la diode 26A en antiparallèle de l'interrupteur 24A de l'ensemble 22 « du haut » de la branche en test. En outre, dans le primaire 64 du transformateur 62, le courant circule dans un deuxième sens, opposé du premier sens et fixé par le circuit inverseur 76 commandé par le module de commande 46.

Ainsi, dans la troisième configuration, comme illustré par la figure 6, le courant passe dans l'interrupteur 24D et diminue en continu en partant de zéro tant que l'interrupteur 24D est fermé. Tant que l'interrupteur 24D est fermé, la tension U_{D} aux bornes de l'interrupteur 24D est nulle. Puis, une fois l'interrupteur 24D rouvert, le courant passe dans la diode 26A en antiparallèle de l'interrupteur 24A et augmente jusqu'à atteindre à nouveau la valeur nulle. Le passage dans la quatrième configuration se fait alors avec un temps mort TM.

Dans la quatrième configuration illustrée en figure 4, seule la tension aux bornes de l'ensemble 22 « du bas » de la branche en test est nulle. Le courant circule dans l'interrupteur 24B de l'ensemble 22 « du bas » de la branche en test et dans la diode 26C en antiparallèle de l'interrupteur 24C de l'ensemble 22 « du bas » de la branche outil 42. En outre, dans le primaire 64 du transformateur 62, le courant circule dans le deuxième sens.

Ainsi, dans la quatrième configuration, comme illustré par la figure 6, le courant passe dans l'interrupteur 24B et augmente en continu en partant de zéro tant que l'interrupteur 24B est fermé. Tant que l'interrupteur 24B est fermé, la tension U_{B} aux bornes de l'interrupteur 24B est nulle. Puis, une fois l'interrupteur 24B rouvert, le courant passe dans la diode 26C en antiparallèle de l'interrupteur 24C et diminue jusqu'à atteindre à nouveau la valeur nulle. Le passage dans la cinquième configuration se fait alors avec un temps mort TM.

Dans la cinquième configuration illustrée en figure 5, seule la tension aux bornes de l'ensemble 22 « du bas » de la branche outil 42 est nulle. Le courant circule dans l'interrupteur 24C de l'ensemble 22 « du bas » de la branche outil 42 et dans la diode 26B en antiparallèle de l'interrupteur 24B de l'ensemble 22 « du bas » de la branche en test. En outre, dans le primaire 64 du transformateur 62, le courant circule dans le premier sens.

Ainsi, dans la cinquième configuration, comme illustré par la figure 6, le courant passe dans l'interrupteur 24C et diminue en continu en partant de zéro tant que l'interrupteur 24C est fermé. Tant que l'interrupteur 24C est fermé, la tension Uc aux bornes de l'interrupteur 24C est nulle. Puis, une fois l'interrupteur 24C rouvert, le courant passe dans la diode 26B en antiparallèle de l'interrupteur 24B et augmente jusqu'à atteindre à nouveau la valeur nulle.

Le module de mesure 48 mesure au cours du temps le courant dans le circuit formé par la branche en test, la branche outil 42 et le secondaire 66 du transformateur 62 (boucle de courant).

Le module de vérification 50 vérifie ensuite le bon fonctionnement de la branche en test en fonction du courant mesuré au cours du temps. Dans un exemple, la forme du signal obtenu pour le courant mesuré est comparée à une forme de signal de référence. Par exemple, la branche en test est considérée valide lorsque la forme du signal mesuré est sensiblement identique à la forme du signal de référence, et est considérée invalide sinon.

Les mêmes étapes sont avantageusement répétées pour toutes les branches de conversion B1, B2, B3 du module de puissance 12. Il est à noter que lorsque la branche outil 42 est une branche de conversion B1, B2, B3, la mise en oeuvre du dispositif de vérification 14 permet de tester deux branches de conversion B1, B2, B3 en même temps.

Ainsi, le dispositif de vérification 14 permet de vérifier le fonctionnement de chaque branche de conversion B1, B2, B3 d'un module de puissance 12 en utilisant un dispositif de test de plus faible puissance que dans l'état de la technique.

En effet, dans l'état de la technique, les interrupteurs 24 des branches de conversion B1, B2, B3 en test reçoivent à la fois une forte tension et un fort courant comme dans leur application réelle. Le dispositif de vérification 14 décrit dans cette demande utilise le principe de la puissance fictive. Chaque interrupteur 24 « croit » ainsi recevoir simultanément une forte tension et un fort courant, alors que la pleine tension provient en réalité d'un premier circuit (le module amont 40) et que le fort courant provient d'un deuxième circuit (le module aval 44). La commande des interrupteurs 24 réalisée par le module de commande 46 permet de faire « croire » aux interrupteurs 24 qu'ils reçoivent à la fois un fort courant et une forte tension.

Le dispositif de vérification 14 décrit permet de tester chaque branche de conversion B1, B2, B3 une à une alors qu'elles sont testées en simultané dans l'état de la technique.

L'un des avantages majeurs du dispositif de vérification 14 décrit réside dans l'économie d'énergie réalisée lors de la mise en oeuvre du test. En outre, un tel dispositif 14 permet de s'affranchir d'une installation de test lourde, volumineuse, coûteuse, à fable consommation d'énergie.

L'homme du métier comprendra que l'invention ne se limite pas aux exemples décrits dans la description et que les modes de réalisation décrits précédemment sont susceptibles d'être combinés lorsqu'une telle combinaison est compatible.

## Revendications

1. Dispositif (14) de vérification du fonctionnement d'un module de puissance (12), le module de puissance (12) comprenant une entrée (E) pour une tension continue d'entrée (Vcc) et un circuit (16) de conversion d'énergie pour trois phases, le circuit de conversion (16) comprenant trois branches de conversion (B1, B2, B3) connectées en parallèle aux bornes de l'entrée (E), chaque branche de conversion (B1, B2, B3) comprenant deux ensembles (22) de composants connectés en série l'un à l'autre, chaque ensemble (22) comprenant au moins un interrupteur (24) avec une diode (26) connectée en antiparallèle,
le dispositif de vérification (14) comprenant :
a. un module amont (40) destiné à être connecté aux bornes de l'entrée (E) du module de puissance (12), le module amont (40) comprenant une première source d'alimentation (51) ayant une tension supérieure ou égale à une première borne de tension et un courant inférieur ou égal à une première borne de courant,
b. une branche outil (42) comprenant deux ensembles (22) de composants connectés en série l'un à l'autre, chaque ensemble (22) comprenant au moins un interrupteur (24) avec une diode (26) connectée en antiparallèle, la branche outil (42) étant destinée à être connectée en parallèle aux bornes de l'entrée (E) du module de puissance (12),
c. un module aval (44) connecté, d'une part, au point milieu (M1, M2, M3) entre les deux ensembles (22) de composants de la branche outil (42) et destiné à être connecté, d'autre part, au point milieu (M1, M2, M3) entre les deux ensembles (22) de composants de l'une des branches de conversion (B1, B2, B3), dite branche en test, de sorte à former une boucle de courant, le module aval (44) comprenant une deuxième source d'alimentation (60) ayant une tension strictement inférieure à une deuxième borne de tension et un courant strictement supérieur à une deuxième borne de courant,
d. un module de commande (46) configuré pour commander les interrupteurs (24) de la branche outil (42) et de la branche en test selon une série de configurations prédéterminées,
e. un module de mesure (48) configuré pour mesurer au cours du temps le courant dans la boucle de courant, et
f. un module de vérification (50) configuré pour vérifier le fonctionnement de la branche en test en fonction du courant mesuré au cours du temps par le module de mesure (48).

2. Dispositif (14) selon la revendication 1, dans lequel :
a. la première borne de tension est supérieure ou égale à 500 Volts, de préférence supérieure ou égale à 700 Volts, avantageusement supérieure ou égale à 1000 Volts,
b. la deuxième borne de tension est inférieure ou égale à 500 Volts, de préférence inférieure ou égale à 300 Volts, avantageusement inférieure ou égale à 200 Volts,
c. la première borne de courant est inférieure ou égale à 10 Ampères, de préférence inférieure ou égale à 5 Ampères, avantageusement inférieure ou égale à 1 Ampère, et
d. la deuxième borne de courant est supérieure ou égale à 10 Ampères, de préférence supérieure ou égale à 30 Ampères, avantageusement supérieure ou égale à 50 Ampères.

3. Dispositif (14) selon la revendication 1 ou 2, dans lequel le module aval (44) comprend un transformateur (62) ayant un primaire (64) et un secondaire (66), le primaire (64) du transformateur (62) étant connecté en parallèle de la deuxième source d'alimentation (60), le secondaire (66) du transformateur (62) étant connecté, d'une part, au point milieu entre les deux ensembles (22) de composants de la branche outil (42) et étant, d'autre part, destiné à être connecté au point milieu (M1, M2, M3) entre les deux ensembles (22) de composants de la branche en test.

4. Dispositif (14) selon la revendication 3, dans lequel le module aval (44) comprend un circuit RL (70) connecté en série du secondaire (66) du transformateur (62).

5. Dispositif (14) selon la revendication 3 ou 4, dans lequel le module aval (44) comprend un circuit inverseur (76), tel qu'un pont en H, le circuit inverseur (76) étant connecté en parallèle de la deuxième source d'alimentation (60) et étant commandé par le module de commande (42).

6. Dispositif (14) selon l'une quelconque des revendications 1 à 5, dans lequel la série de configurations prédéterminées du module de vérification (50) comprend au moins les configurations suivantes : une première configuration dans laquelle le ou les interrupteurs (24) de chaque ensemble (22) sont ouverts, une deuxième configuration dans laquelle seuls le ou les interrupteurs (24) de l'un des ensembles (22) de la branche en test est fermé, une troisième configuration dans laquelle seul(s) le ou les interrupteurs (24) de l'un des ensembles (22) de la branche outil (42) est fermé, une quatrième configuration dans laquelle seul(s) le ou les interrupteurs (24) de l'autre des ensembles (22) de la branche en test est fermé et une cinquième configuration dans laquelle seul(s) le ou les interrupteurs (24) de l'autre des ensembles (22) de la branche outil (42) est fermé.

7. Dispositif (14) selon l'une quelconque des revendications 1 à 6, dans lequel le module de vérification (50) est configuré pour comparer la forme du signal représentatif du courant mesuré au cours du temps par le module de mesure (48), à une forme d'un signal de référence.

8. Installation électrique (10) comprenant :
a. un module de puissance (12) comprenant une entrée (E) pour une tension continue d'entrée (Vcc) et un circuit (16) de conversion d'énergie pour trois phases, le circuit de conversion (16) comprenant trois branches de conversion (B1, B2, B3) connectées en parallèle aux bornes de l'entrée (E), chaque branche de conversion (B1, B2, B3) comprenant deux ensembles (22) de composants connectés en série l'un à l'autre, chaque ensemble (22) comprenant au moins un interrupteur (24) avec une diode (26) connectée en antiparallèle,
b. un dispositif (14) de vérification du fonctionnement du module de puissance (12), le dispositif de vérification (14) étant selon l'une quelconque des revendications 1 à 7.

9. Installation électrique (10) selon la revendication 8, dans laquelle la branche outil (42) du dispositif de vérification (14) est une branche de conversion (B1, B2, B3) du module de puissance (12), différente de la branche en test.

10. Installation électrique (10) selon la revendication 8 ou 9, dans laquelle le module de puissance (12) est configuré pour fonctionner sous une puissance supérieure ou égale à 500 Kilowatt, de préférence supérieure ou égale à 1 Mégawatt.

## Patentansprüche

1. Vorrichtung (14) zur Überprüfung der Funktion eines Leistungsmoduls (12), wobei das Leistungsmodul (12) einen Eingang (E) für eine Eingangsgleichspannung (Vcc) und eine Dreiphasen-Energieumwandlungsschaltung (16) umfasst, wobei die Umwandlungsschaltung (16) drei Umwandlungszweige (B1, B2, B3) umfasst, die mit den Anschlüssen des Eingangs (E) parallel verbunden sind, wobei jeder Umwandlungszweig (B1, B2, B3) zwei Bauteilanordnungen (22) umfasst, die in Reihe miteinander verbunden sind, wobei jede Anordnung (22) mindestens einen Schalter (24) mit einer antiparallel verbundenen Diode (26) umfasst,
wobei die Überprüfungsvorrichtung (14) umfasst:
a. ein vorgeschaltetes Modul (40), das dazu bestimmt ist, mit den Anschlüssen des Eingangs (E) des Leistungsmoduls (12) verbunden zu sein, wobei das vorgeschaltete Modul (40) eine erste Stromquelle (51) mit einer Spannung hat, die größer oder gleich einem ersten Spannungsanschluss ist, und einem Strom, der kleiner oder gleich einem ersten Stromanschluss ist,
b. einen Werkzeugzweig (42), der zwei Bauteilanordnungen (22) umfasst, die in Reihe miteinander verbunden sind, wobei jeder Anordnung (22) mindestens einen Schalter (24) mit einer Diode (26) umfasst, die antiparallel verbunden ist, wobei der Werkzeugzweig (42) dazu bestimmt ist, mit den Anschlüssen des Eingangs (E) des Leistungsmoduls (12) parallel verbunden zu sein,
c. ein nachgeschaltetes Modul (44), das einerseits mit dem Mittelpunkt (M1, M2, M3) zwischen den beiden Bauteilanordnungen (22) des Werkzeugzweigs (42) verbunden ist und dazu bestimmt ist, andererseits mit dem Mittelpunkt (M1, M2, M3) zwischen den beiden Bauteilanordnungen (22) eines der Umwandlungszweige (B1, B2, B3), bezeichnet als Testzweig, derart verbunden zu sein, dass eine Stromschleife gebildet wird, wobei das nachgeschaltete Modul (44) eine zweite Stromquelle (60) mit einer Spannung strikt unter einem zweiten Spannungsanschluss und einem Strom strikt über einem zweiten Stromanschluss umfasst,
d. ein Steuermodul (46), das ausgelegt ist, um die Schalter (24) des Werkzeugzweigs (42) und des Testzweigs gemäß einer Reihe vorbestimmter Konfigurationen zu steuern,
e. ein Messmodul (48), das ausgelegt ist, um den Strom in der Stromschleife im Laufe der Zeit zu messen, und
f. ein Überprüfungsmodul (50), das ausgelegt ist, um die Funktion des Testzweigs in Abhängigkeit von dem im Laufe der Zeit vom Messmodul (48) gemessen Strom zu überprüfen.

2. Vorrichtung (14) nach Anspruch 1, wobei:
a. der erste Spannungsanschluss größer oder gleich 500 Volt, vorzugsweise größer oder gleich 700 Volt, in vorteilhafter Weise größer oder gleich 1000 Volt ist,
b. der zweite Spannungsanschluss kleiner oder gleich 500 Volt, vorzugsweise kleiner oder gleich 300 Volt, in vorteilhafter Weise kleiner oder gleich 200 Volt ist,
c. der erste Stromanschluss kleiner oder gleich 10 Ampere, vorzugsweise kleiner oder gleich 5 Ampere, in vorteilhafter Weise kleiner oder gleich 1 Ampere ist, und
d. der zweite Stromanschluss größer oder gleich 10 Ampere, vorzugsweise größer oder gleich 30 Ampere, in vorteilhafter Weise größer oder gleich 50 Ampere ist.

3. Vorrichtung (14) nach Anspruch 1 oder 2, wobei das nachgeschaltete Modul (44) einen Transformator (62) mit einer Primär- (64) und einer Sekundärseite (66) umfasst, wobei die Primärseite (64) des Transformators (62) mit der zweiten Stromquelle (60) parallel verbunden ist, wobei die Sekundärseite (66) des Transformators (62) einerseits mit dem Mittelpunkt zwischen den beiden Bauteilanordnungen (22) des Werkzeugzweigs (42) verbunden ist und andererseits dazu bestimmt ist, mit dem Mittelpunkt (M1, M2, M3) zwischen den beiden Bauteilanordnungen (22) des Testzweigs verbunden zu sein.

4. Vorrichtung (14) nach Anspruch 3, wobei das nachgeschaltete Modul (44) eine RL-Schaltung (70) umfasst, die mit der Sekundärseite (66) des Transformators (62) in Reihe verbunden ist.

5. Vorrichtung (14) nach Anspruch 3 oder 4, wobei das nachgeschaltete Modul (44) eine Wechselrichterschaltung (76) wie eine H-Brücke umfasst, wobei die Wechselrichterschaltung (76) mit der zweiten Stromquelle (60) parallel verbunden ist und von dem Steuermodul (42) gesteuert wird.

6. Vorrichtung (14) nach einem der Ansprüche 1 bis 5, wobei die Reihe vorbestimmter Konfigurationen des Überprüfungsmoduls (50) mindestens die folgenden Konfigurationen umfasst: eine erste Konfiguration, bei der der oder die Schalter (24) jeder Anordnung (22) geöffnet sind, eine zweite Konfiguration, bei der nur der oder die Schalter (24) einer der Anordnungen (22) des Testzweigs geschlossen ist/sind, eine dritte Konfiguration, bei der nur der oder die Schalter (24) einer der Anordnungen (22) des Werkzeugzweigs (42) geschlossen ist/sind, eine vierte Konfiguration, bei der nur der oder die Schalter (24) der anderen der Anordnungen (22) des Testzweigs geschlossen ist/sind, und eine fünfte Konfiguration, bei der nur der oder die Schalter (24) der anderen der Anordnungen (22) des Werkzeugzweigs (42) geschlossen ist/sind.

7. Vorrichtung (14) nach einem der Ansprüche 1 bis 6, wobei das Überprüfungsmodul (50) ausgelegt ist, um die Form des Signals, das für den im Laufe der Zeit von dem Messmodul (48) gemessen Strom repräsentativ ist, mit einer Form eines Referenzsignals zu vergleichen.

8. Elektrische Anlage (10), umfassend:
a. ein Leistungsmoduls (12), das einen Eingang (E) für eine Eingangsgleichspannung (Vcc) und eine Dreiphasen-Energieumwandlungsschaltung (16) umfasst, wobei die Umwandlungsschaltung (16) drei Umwandlungszweige (B1, B2, B3) umfasst, die mit den Anschlüssen des Leistungsmoduls (12) parallel verbunden sind, wobei jeder Umwandlungszweig (B1, B2, B3) zwei Bauteilanordnungen (22) umfasst, die in Reihe miteinander verbunden sind, wobei jede Anordnung (22) mindestens einen Schalter (24) mit einer antiparallel verbundenen Diode (26) umfasst,
b. eine Vorrichtung (14) zur Überprüfung der Funktion des Leistungsmoduls (12), wobei die Überprüfungsvorrichtung (14) nach einem der Ansprüche 1 bis 7 ist.

9. Elektrische Anlage (10) nach Anspruch 8, wobei der Werkzeugzweig (42) der Überprüfungsvorrichtung (14) ein Umwandlungszweig (B1, B2, B3) des Leistungsmoduls (12) ist, der sich vom Testzweig unterscheidet.

10. Elektrische Anlage (10) nach Anspruch 8 oder 9, wobei das Leistungsmodul (12) dazu ausgelegt ist, mit einer Leistung größer oder gleich 500 Kilowatt, vorzugsweise größer oder gleich 1 Megawatt, zu funktionieren.

## Claims

1. A device (14) for checking the operation of a power module (12), the power module (12) comprising an input (E) for an input DC voltage (Vcc) and an energy conversion circuit (16) for three phases, the conversion circuit (16) comprising three conversion branches (B1, B2, B3) connected in parallel to the terminals of the input (E), each conversion branch (B1, B2, B3) comprising two sets (22) of components connected in series with each other, each set (22) comprising at least one switch (24) with a diode (26) connected in antiparallel,
the checking device (14) comprising:
a. an upstream module (40) intended to be connected to the terminals of the input (E) of the power module (12), the upstream module (40) comprising a first power source (51) having a voltage greater than or equal to a first voltage terminal and a current less than or equal to a first current terminal,
b. a tool branch (42) comprising two sets (22) of components connected in series with each other, each set (22) comprising at least one switch (24) with a diode (26) connected in antiparallel, the tool branch (42) being intended to be connected in parallel to the terminals of the input (E) of the power module (12),
c. a downstream module (44) connected, on the one hand, to the mid-point (M1, M2, M3) between the two sets (22) of components of the tool branch (42) and intended to be connected, on the other hand, to the mid-point (M1, M2, M3) between the two sets (22) of components of one of the conversion branches (B1, B2, B3), referred to as the branch being tested, so as to form a current loop, the downstream module (44) comprising a second power source (60) having a voltage strictly lower than a second voltage terminal and a current strictly higher than a second current terminal,
d. a control module (46) configured to control the switches (24) of the tool branch (42) and the branch being tested according to a series of predetermined configurations,
e. a measurement module (48) configured to measure the current in the current loop over time, and
f. a checking module (50) configured to check the operation of the branch being tested as a function of the current measured over time by the measurement module (48).

2. The device (14) according to claim 1, wherein:
a. the first voltage terminal is greater than or equal to 500 Volts, preferably greater than or equal to 700 Volts, advantageously greater than or equal to 1,000 Volts,
b. the second voltage terminal is less than or equal to 500 Volts, preferably less than or equal to 300 Volts, advantageously less than or equal to 200 Volts,
c. the first current terminal is less than or equal to 10 Amps, preferably less than or equal to 5 Amp, advantageously less than or equal to 1 Amps, and
d. the second current terminal is greater than or equal to 10 Amps, preferably greater than or equal to 30 Amps, advantageously greater than or equal to 50 Amps.

3. The device (14) according to claim 1 or 2, wherein the downstream module (44) comprises a transformer (62) having a primary (64) and a secondary (66), the primary (64) of the transformer (62) being connected in parallel with the second power source (60), the secondary (66) of the transformer (62) being connected, on the one hand, to the mid-point between the two sets (22) of components of the tool branch (42) and, on the other hand, being intended to be connected to the mid-point (M1, M2, M3) between the two sets (22) of components of the branch being tested.

4. The device (14) according to claim 3, wherein the downstream module (44) comprises an RL circuit (70) connected in series with the secondary (66) of the transformer (62).

5. The device (14) according to claim 3 or 4, wherein the downstream module (44) comprises an inverter circuit (76), such as an H-bridge, the inverter circuit (76) being connected in parallel with the second power source (60) and being controlled by the control module (42).

6. The device (14) according to any one of claims 1 to 5, wherein the series of predetermined configurations of the checking module (50) comprises at least the following configurations: a first configuration in which the switch or switches (24) of each set (22) are open, a second configuration in which only the switch or switches (24) of one of the sets (22) of the branch being tested is closed, a third configuration in which only the switch or switches (24) of one of the sets (22) of the tool branch (42) is closed, a fourth configuration in which only the switch or switches (24) of the other of the sets (22) of the branch being tested is closed, and a fifth configuration in which only the switch or switches (24) of the other of the sets (22) of the tool branch (42) is closed.

7. The device (14) according to any one of claims 1 to 6, wherein the checking module (50) is configured to compare the shape of the signal representative of the current measured over time by the measurement module (48) with the shape of a reference signal.

8. An electrical installation (10) comprising:
a. a power module (12) comprising an input (E) for an input DC voltage (Vcc) and an energy conversion circuit (16) for three phases, the conversion circuit (16) comprising three conversion branches (B1, B2, B3) connected in parallel to the terminals of the input (E), each conversion branch (B1, B2, B3) comprising two sets (22) of components connected in series with each other, each set (22) comprising at least one switch (24) with a diode (26) connected in antiparallel,
b. a device (14) for checking the operation of the power module (12), the checking device (14) being according to any one of claims 1 to 7.

9. The electrical installation (10) according to claim 8, wherein the tool branch (42) of the checking device (14) is a conversion branch (B1, B2, B3) of the power module (12), different from the branch being tested.

10. The electrical installation (10) according to claim 8 or 9, wherein the power module (12) is configured to operate at a power greater than or equal to 500 Kilowatts, preferably greater than or equal to 1 Megawatt.
